# EUROPEAN PATENT SPECIFICATION

(11) **EP 3 310 863 B1**
(45) Date of publication and mention of the grant of the patent: **22.05.2024**
(21) Application number: 16751002.3
(22) Date of filing: 22.06.2016
(51) Int. Cl.: C09D 5/24, H05K 9/00, C01B 32/19, C01B 32/225, G21F 1/02, C08K 3/04

(54) **WATER-BASED PIEZORESISTIVE CONDUCTIVE POLYMERIC PAINT CONTAINING GRAPHENE FOR ELECTROMAGNETIC AND SENSOR APPLICATIONS**
WÄSSRIGER PIEZORESISTIVER UND LEITFÄHIGER POLYMERISCHER LACK MIT GRAPHEN FÜR ELEKTROMAGNETISCHEN ANWENDUNGEN UND FÜR SENSOR
PEINTURE CONDUCTRICE À BASE AQUEUSE ET PIÉZORÉSISTIVE CONTENAT DU GRAPHÈNE POUR DES APPLICATIONS ÉLECTROMAGNÉTIQUES ET DE DÉTECTEUR

(30) Priority: 22.06.2015 IT UB20151565
(43) Date of publication of application: 25.04.2018
(73) Proprietor: Università degli Studi di Roma "La Sapienza", 00185 Roma (IT)
(72) Inventor: SARTO, Maria Sabrina, I-00185 Roma (IT); TAMBURRANO, Alessio, I-00185 Roma (IT); PROIETTI, Alessandro, I-00185 Roma (IT); RINALDI, Andrea, I-00185 Roma (IT); PALIOTTA, Licia, I-00185 Roma (IT)
(74) Representative: Sarpi, Maurizio
(86) International application number: PCT/IB2016/053699
(87) International publication number: WO 2016/207804

(56) References cited:
- WO-A1-2008/143692
- WO-A2-2014/061048
- DE-A1- 4 006 352
- FR-A1- 2 720 194
- US-A1- 2005 284 232
- US-A1- 2010 147 188
- US-A1- 2013 065 034
- US-A1- 2015 044 564
- BAO C., GUO Y.,SONG L., HU Y.: "Poly(vinyl alcohol) nanocomposites based on graphene and graphite oxide:a comparative investigation of property and mechanism", JOURNAL OF MATERIALS CHEMISTRY, vol. 21, 11 August 2011 (2011-08-11), pages 13942-13950, XP002754084,
- CAROTENUTO G; SCHIAVO L; ROMEO V; NICOLAIS L: "Deformation sensor based on polymer-supported discontinuous graphene multi-layer coatings e>93", AIP CONFERENCE PROCEEDINGS - TIMES OF POLYMERS (TOP) AND COMPOSITES 2014 - PROCEEDINGS OF THE 7TH INTERNATIONAL CONFERENCE ON TIMES OF POLYMERS (TOP) AND COMPOSITES, vol. 1599, 22 June 2014 (2014-06-22), - 26 June 2014 (2014-06-26), pages 18-21, XP002754085,

## Description

### 1. Field of the invention

The present invention belongs to the field of nanotechnologies and more specifically regards the production of new nanostructured and graphene-based materials, presenting controlled electrical, electromagnetic, and electromechanical properties.

In particular, the present invention regards formulation and production of a water-based polymeric paint, which has controlled electrical or else piezoresitive or else electromagnetic properties, starting from a commercial water-based polymeric paint or else from a water-based polymeric liquid solution filled with graphene nanoplatelets (GNPs), obtained by means of exfoliation of expanded graphite. Said paint can be used in electromagnetic-shielding applications (for example, for producing radar-absorbent materials (RAMs) or else for producing antistatic devices or piezoresistive coatings for distributed monitoring of the strain state of a structure.

In addition to the aforesaid electrical, piezoresistive, and electromagnetic characteristics, the coatings thus obtained are light, easy to process, and suitable for being laid on any substrate.

All the purposes of the invention have been achieved through the process according to claims 1 to 12 and 18, the polymeric film according to claim 13 , the uses according to claims 14 to 16 and the sensor according to claim 17.

The process developed for producing said paint is simple, inexpensive, fast, and suitable for low-cost mass production. Moreover, it makes use of alcohol-water mixtures as solvent.

It envisages the following steps:
a) subjecting commercial graphite intercalation compound (GIC) to thermal expansion to obtain structures known as TEGO, WEG, or expanded graphite (EG), or else using EG of a commercial type;
b) dispersing and shredding said TEGO, WEG, or EG structures in water-based paint/ polymer, possibly diluted with alcohol-water mixture in variable concentrations according to the desired final properties; and
c) subjecting the suspension to ultrasonication, wherein the sonication cycle parameters such as the temperature of the suspension, the energy released and the duration are defined on the basis of the properties of the material that has to be obtained.

The paint can be laid with multiple techniques, such as, by way of non-limiting example, spraying, dip-coating, and ink-jet.

Advantageously, according to the invention, it is possible to control the electrical, piezoresistive, and electromagnetic properties of the coating obtained with said paint through:
1. The amount of GNPs dispersed within the matrix;
2. The definition and concentration of the alcohol-water mixture used as solvent; and
3. Control of the dispersion of the GNPs within the paint,

Wherein said control is obtained through the sequential action of a mechanical rod stirrer, which has the function of shredding the expanded graphite in suspension, and of a sonicator with ultrasound tip, which has the function of exfoliating and dispersing the expanded graphite previously shredded.

### 2. Description

### Prior art

The increasingly widespread use of composite materials in the aerospace sector, military sector, automotive sector, etc. is leading to the development of electrically conductive composite materials in order to provide solutions for distributed sensing, electromagnetic shielding, and suppression of electromagnetic interference, which can be easily integrated in the production chain of a composite material.

Consequently, there is a considerable interest in the development of new technologies and new polymeric-matrix and electrically conductive composite materials. These composite materials may be obtained either using insulating matrices or using electrically conductive matrices. Some of the most deeply studied fillers are carbon nanostructures, whether in the form of reduced graphite oxide (rGO), or in the form of functionalized graphene sheets (FGSs), or in the form of graphite/graphene nanoplatelets (GNPs), or in the form of carbon nanotubes (CNTs). One of the most investigated aspects regards the possibility of providing conductive coatings.

There now follows a brief analysis and commentary on a series of patents and scientific papers distinguished by the numbers appearing in the list of references at the end of the present description.

The patents [1], [2], [3], and [4] regard development of graphene-based nanostructures, such as graphite nanoplatelets and graphene nanosheets and manufacture of polymeric nanocomposites that contain said nanostructures as fillers.

The patent US 7658901 [1] "Thermally exfoliated graphite oxide" describes the method for producing TEGO (Thermally Exfoliated Graphite Oxide) starting from the Staudenmaier method and with expansions at up to 3000°C with rates of up to and beyond 2000°C/min and for manufacturing the corresponding nanocomposites, which are on the other hand characterized in terms of DC and AC electrical conductivity.

Instead, according to the present invention, the starting material is a low-cost and readily available material, such as, by way of non-limiting example, graphite intercalation compound (GIC) of a commercial type, or else it may be produced starting from natural graphite or kish; the step of expansion occurs in air (and not in controlled atmosphere) and with a rate even much higher than 2000°C/min. For example, in the case of the GIC expanded at 1150°C for 5 s, the rate is as high as 13800°C/min.

The patent WO 2014140324 A1 [3] "A scalable process for producing exfoliated defect-free, non-oxidised 2-dimensional materials in large quantities" describes exfoliation in liquid phase of nanostructures of various nature, including graphene, by means of a process that is of an exclusively mechanical nature.

The present invention differs in so far as the process of exfoliation of the GNPs is based upon shredding in a liquid of the expanded graphite and upon subsequent exfoliation by means of sonication with ultrasound probe. Shredding in a liquid is carried out by combined use of a mechanical rod stirrer and/or of a high-shear mixer. The shredding step is moreover optimized in terms of duration and speed of rotation of the stirrer or of the high-shear mixer. The aim of the aforesaid step is not exfoliation at a nanometric level of the expanded graphite, but shredding thereof on a micrometric scale (with production of particles of dimensions comprised between 1 µm and 500 pm) in such a way as to increase considerably the surface of interface between the expanded graphite and the liquid phase so as to facilitate the subsequent sonication step by means of ultrasound probe (ultrasonication).

The procedure proposed herein adopts only in part the procedure developed in the patent [4] WO 2014061048 A2 "Gnp-based polymeric nanocomposites for reducing electromagnetic interferences" in so far as in the aforementioned patent the step of mechanical shredding is absent, and there is envisaged sonication of the expanded graphite in an appropriate solvent, mixing with the polymer in liquid phase, and then a single final step of total evaporation of the solvent where the polymer/nanostructures/solvent mixture is kept stirred by means of a mechanical or magnetic stirrer.

In the literature some examples of conductive films with a base of poly(vinyl alcohol) with carbon-based fillers are present. Chen Lu et *al.* in [5] describe production of a nanocomposite starting from PVA and natural graphite. Natural graphite is oxidized using the Hummer method and mixed with PVA, previously dissolved in water. The solution of PVA and graphene oxide (GO) is mixed for three days and then poured to obtain a film. The film of PVA and reduced graphene oxide (rGO) is produced using a strategy similar to the PVA/GO case, but after the second day of mixing hydrazine is added to reduce GO to rGO. The final composites show a low electrical conductivity, of approximately 10⁻⁹ S/m in the case of rGO.

Horacio et *al.* in [6] describe production of a nanocomposite with PVA and rGO matrix using 2-propanol as coagulant, to cause precipitation of the nanocomposite. Even for high filler concentrations (10 wt%), the electrical conductivity remains of the order of 0.1 S/m. A similar approach is used in the present invention where 1-propanol is used both to improve exfoliation of the expanded graphite, as shown in [7], and to bring about precipitation of the nanocomposite.

Sriya et *al.* in [8] describe production of an aqueous suspension of graphene nanoplatelets rendered stable with the aid of a stabilizing agent (C10). By then adding PVA, a conductive nanocomposite is obtained with conductivity of the order of 10⁻⁴ S/m for concentrations of 3 vol%.

T. N. Zhou et *al.* in [9] describe production of a PVA/rGO nanocomposite with conductivity of the order of 10⁻³ S/m. The method proposed is very simple and consists of three steps. In the first step it is envisaged to produce rGO, which is mixed in aqueous suspension with PVA in the second step, while in the last step filtration of the nanocomposite is carried out. Carotenuto et al. in AIP CONFERENCE PROCEEDINGS -

TIMES OF POLYMERS (TOP) AND COMPOSITES 2014 - PROCEEDINGS OF THE 7TH INTERNATIONAL CONFERENCE ON TIMES OF POLYMERS (TOP) AND COMPOSITES, vol. 1599, 22 June 2014 (2014-06-22), - 26 June 2014 (2014-06-26), pages 18-21 disclose the fabrication of transparent resistive deformation sensors based on low-density polyethylene films coated by graphene multilayers

The patents [10], [11], [12], [13], [14], [15], [16], [17], [18], [19], and [20] investigate various strategies whereby it is possible to produce a polymeric material, possibly water-based and electrically conductive.

The patent US 5286415 [10] "Water-based polymer thick film conductive ink" presents a process of production of a thick film of conductive thermoplastic polymer, amongst which PVA, filled with graphite, silver microparticles, or carbon black up to 40 wt% with the addition of a polymerisation-retardant agent. The patent discusses the production of an electrically conductive film (sheet resistance lower than 20 mQ) obtained by inclusion of micrometric fillers dispersed in the matrix by means of a mechanical stirrer. Instead, according to the present invention, an electrically conductive water-based polymeric paint incorporating graphene nanoplatelets is provided.

The patent US 20080171824 [11] "Polymers filled with highly expanded graphite" describes the development of a conductive polymer filled with expanded graphite, starting from intercalated graphite. Various polymers are indicated, amongst which PVA. The dispersion method is described as a thermo-chemical process in solution, without the aid of sonication. Amongst the best results reported, there may be cited a volume resistivity of the order of 10² Qcm for epoxy resins filled at 4 wt%. The patent does not examine the possibility of exfoliating the expanded graphite to obtain a better distribution of the filler within the matrix so as to improve the performance thereof.

The patent CN 101671466A [12] "Conductive polyvinyl alcohol and preparation method thereof" presents a manufacturing process for obtaining a conductive PVA film filled with expanded graphite.

The process presented implies various steps of stirring at different temperatures, with a number of sonications of the duration of several hours. The electrical conductivity reached does not exceed 10⁻⁴ S/m, even though the material shows excellent mechanical characteristics in terms of ultimate elongation (of up to 340%).

The patent CN 102516829A [13] "Ultransonic-assisted method for preparing polymer functionalized graphene" describes how to functionalize graphene with polymers (amongst which PVA) by means of an ultrasonication process. This patent does not describe preparation of a nanocomposite but a physico-chemical process where graphene is functionalized with a polymer.

The patent CN 103131232A [15] "High-performance aqueous graphene paint and preparation method thereof" presents a process of preparation of a water-based paint filled with rGOs produced by means of the Hummer method. During the production process various additives are used, amongst which neutralizing agents, antifoaming agents, dispersing agents, etc. The process is hence complex from the chemical standpoint, requiring a large variety of reagents.

The patent EP 2262727 A2 [16] "Graphite nanoplatelets and compositions" describes production of conductive polymers, amongst which polyurethane-based ones, using GNPs as filler. GNPs are directly dispersed in the polymer via ultrasonication, without passing through the steps of shredding and sonication in solvent that, instead, characterize the present invention. For this reason, even though the manufacturing process is extremely simple, the surface resistances achieved by the film obtained do not go below 1.4 kΩ/sq.

The patent WO 20130074712 A1 [17] "Graphene containing composition" describes production of an ink or a coating with a base of graphene and at least one acid. These components are added to a polymer that may be polyvinyl butyral or else polyvinyl formal or else (water soluble) polyacrylates. Instead, the present invention does not make use of acids.

The patent US 201302067294 A1 [18] "Conductive paint composition and method for manufacturing conductive film using the same" protects the production and composition of a polymeric paint (possibly even water-based) rendered electrically conductive by inclusion of carbon nanostructures. One of the key steps of the process protected by this patent is a treatment of oxidation of the surface of the nanostructures obtained by putting them in water in supercritical or subcritical conditions and using one or more oxidizing agents chosen from among oxygen, hydrogen peroxide, air, ozone, and mixtures thereof. In the present patent application, the carbon nanostructures do not undergo any oxidation treatment aimed at modifying their surface.

The patent US 20130001462 A1 [19] "Method for manufacturing polyurethane nanocomposite comprising expanded graphite and composition thereof" protects the process of production of a nanocomposite with polymeric matrix (including polyurethane) obtained starting from expanded graphite (EG), dispersed in an organic solvent such as dimethylformamide, methyl ethyl ketone, toluene, and acetone; next, the EG-solvent mixture is added to a prepolymer, and the subsequent polycondensation reaction leads to exfoliation of the expanded graphite and to formation of the nanocomposite. Instead, according to the present invention, the solvent used is an alcohol-water mixture, and exfoliation of the expanded graphite occurs using an ultrasound tip.

Other methods for rendering a water-based polymeric film conductive are presented in the patents US 20050181206 [14] "Conductive polyvinyl alcohol fiber" and WO 2011008227 A1 [20] "Transparent conductive film comprising water soluble binders", which use intrinsically conductive copolymers or metal particles. Instead, the present invention does not envisage use either of metal fillers or of intrinsically conductive polymers.

For applications of electromagnetic shielding there exist in the literature multiple composite materials that use conductive metal fillers or carbon-based fillers. Among the patents that are most relevant for the subject of the present invention there may be mentioned [21], [22], [23], and [24].

The patents [21], [22], and [23] provide polymeric composites filled with various carbon nanostructures and/or metal fillers. Unlike the present invention, they do not provide paints.

Described in the patent CN 1450137 [24] "Aqueous emulsion type electromagnetic wave shielded coating and preparation process thereof" is the possibility of providing conductive films of water-based polymers for applications of electromagnetic shielding. These films are obtained using resins of various types dissolved in water, filled with metal-based conductive fillers in large amounts, ranging between 20 wt% and 60 wt%. Instead, according to the present invention, use of metal particles is not envisaged.

The use of conductive composites with polymeric matrix as strain sensors is of considerable interest thanks to the possibility of integration thereof in light structures made of composite material. In the literature there may be found examples of thermoplastic or thermosetting resins, filled with carbon-based fillers for strain-sensing applications. The most relevant patents for the purposes of the present invention that describe production of piezoresistive films for strain monitoring are [20], [25], [26], and [27] . In particular, they present the possibility of producing piezoresistive polymers filled with carbon nanotubes, carbon nanofibres, carbon black, or amorphous carbon to be used as strain sensors. Unlike the aforementioned patents, according to the present invention, GNPs are used as conductive filler.

Loh et *al.* in [28] present the production of a PVA-based conductive film filled with carbon nanotubes to be used as sensor for detection distributed over a surface of strains and damage or defects. Detection of strain or damage is carried out through the technique of electrical impedance tomography (EIT). The sensors developed present a sensitivity of up to approximately 6. Instead, according to the present invention, as fillers of the polymer carbon nanotubes are not used but GNPs, consequently obtaining sensors that present a sensitivity higher than 10 and, by way of non-limiting example, of up to 55.

The applications of conductive polymers for producing absorbent radar structures are increasingly widespread. Some reference patents are mentioned hereinafter.

The patent WO 2010109174 A1 [29] "Electromagnetic field absorbing composition" develops a composite filled with carbon-based micrometric structures for RAM applications. Instead, according to the present invention, GNPs are used as fillers.

The patent WO 2014061048A2 [4] "GNP-based polymeric nanocomposites for reducing electromagnetic interferences" develops a composite with a thermosetting matrix filled with GNPs for RAM applications. The authors also claim a process of production of nanostructures based upon ultrasonication. Unlike the present invention, this patent does not provide a paint, and the process described does not envisage the step of mechanical shredding or the use of alcohol-water mixtures as solvent.

The document FR272019A1 pertains to the production of radar-absorbing material, which is achieved by coating an aramidic honeycomb structure (NOMEX) with carbon fibers, rather than graphene. Therefore, it addresses a different subject matter. Additionally, it would not have been feasible for a skilled person to utilize the material described in the prior WO 2014061048A2 to create a thin conductive paint for electromagnetic wave energy absorption. This is because the bulk composite mentioned in the document does not allow for the coating of the cells within a honeycomb structure.

The list could be much longer, but a fundamental characteristic of these patents is that the conductive filled polymer is in any case a thermosetting or a thermoplastic polymer with high viscosity and in any case not suitable for production of a conductive paint that is able to provide in a simple way coats with a thickness of some microns or tens of microns having a surface resistance of a desired value, in any case ranging from tens or hundreds of kilo-ohms to hundreds of ohms. This aspect represents, together with the step of mechanical shredding and the use of alcohol-water mixtures as solvent, the main distinctive characteristic of the present patent application as compared to the prior patent application filed by the present applicant in 2012 entitled: "Nanocompositi polimerici a base di GNP per la riduzione di interferenze elettromagnetiche" ("GNP-based nanopolymeric composites for reduction of electromagnetic interference").

### Description of the invention

The present invention relates to production of a water-based conductive polymeric paint for providing thin conductive, antistatic, and possibly piezoresistive coatings starting from a liquid water-based polymer or else from a water-based polymeric paint (by way of example, according to the present invention, polyvinyl alcohol - PVA - or else a polyurethane paint are used) filled with graphene nanoplatelets (GNPs).

According to the invention, starting from commercial graphite intercalation compound (GIC) (Grafguard 160-50N), via thermal expansion, according to the known art, structures are obtained known as thermally expanded graphite oxide (TEGO) or worm-like expanded graphite (WEG) or simply expanded graphite (EG). Alternatively, it is possible to use expanded graphite of a commercial type.

The aforesaid EG is dispersed and shredded in a liquid (typically an alcohol-water mixture or else a water-based paint/polymer possibly diluted with an alcohol-water mixture), via the aid of a mechanical rod stirrer and/or a high-shear mixer. The composition of the liquid phase where dispersion and shredding of the EG is carried out is identified with the aim of maximizing the wettability of the expanded graphite therein. The process steps that follow differ in relation to the different composition of the liquid phase.

In the case of an alcohol-water mixture, the process that follows the step of dispersion and shredding in a liquid consists of:
i. sonication with ultrasound probe as described hereinafter;
ii. partial evaporation of the alcohol-water mixture (from 90% to 99% of its total volume);
iii. mixing with water-based polymer and/or paint by means of mechanical mixing and/or sonication;
iv. possible addition of a crosslinking agent;
v. deposition on a substrate; and
vi. curing.

In the case of a water-based polymer or paint possibly diluted in an alcohol-water mixture, the process that follows the step of dispersion and shredding in a liquid consists of:
i. sonication with ultrasound probe as described hereinafter;
ii. possible total evaporation of the solvent;
iii. addition of a cross-linking agent where required;
iv. deposition on a substrate; and
v. curing.

The parameters of the sonication cycle such as temperature of the solution, energy released, duration, etc. appearing in the examples provided below, are set according to the starting material and to the properties of the material that is to be obtained. Prior to the final curing step, the suspension obtained is thus ready for deposition on any substrate through various techniques, among which dip-casting, spin-coating, spraying, and ink-jet.

The total duration of the process of preparation of the filled conductive paint is from approximately 30-40 min to a maximum of approximately 120 min. It is hence much shorter than the duration of the processes described in the aforementioned patents (typically several hours shorter).

The process illustrated presents considerable advantages over the ones known in the literature or described in other patents in terms of simplicity, rapidity, low-cost, and scalability. Moreover, it enables dispersion in the polymeric matrix of high concentrations of GNPs in order to obtain a higher performance as compared to any composite previously produced belonging to this category, in particular in terms of electrical conductivity and piezoresistive response.

### Example No. 1 of the production process: PVA-based paint

The process of production of the PVA-based paint forming the subject of the present invention consists of the following steps:
a) PRODUCTION OF EXPANDED GRAPHITE (EG): This step uses as starting material graphite intercalation compound (GIC) of a commercial type (Grafguard 160-50N). Through heating in an oven at a temperature of 1150°C for 5 s with a rate of up to 13800°C/min, the intercalating acids of the GIC undergo fast expansion, moving apart the graphite layers. The structures obtained, which go by the name of WEG, have a volume that is approximately 200-300 times that of the GIC and are suitable for being dispersed in solvent.
b) DISPERSION AND SHREDDING: The EG is dispersed and shredded in an appropriate amount of liquid PVA (10-250 ml) with the aid of a mechanical rod stirrer and/or using a high-shear mixer, in a weight percentage ranging between 0.01 wt% and 20 wt%. To facilitate dispersion of the GNPs (and then the subsequent exfoliation step), added to the PVA is 1-propanol or alcohol-water mixture in an amount of between 1 ml/mg and 30 ml/mg in relation to the amount of EG dispersed. Moreover, in order to reduce the viscosity of the suspension, there may be possibly added demineralized water in an amount proportional to the content of EG and in any case in an amount of between 0.001 ml/mg and 0.060 ml/mg.
c) ULTRASONICATION AND EXFOLIATION: Next, the suspension is subjected to ultrasonication with 1:1 pulsed cycle with a power of between 40 W and 50 W for a total time ranging between 20 and 60 min. The solution is kept at a constant temperature of between 5°C and 15°C to prevent evaporation of the solvent and maintain the sonication conditions unaltered.

At the end of the sonication process, the suspension presents a viscosity suitable for deposition on the surface of interest in different ways, amongst which dip-casting, spin-coating, or spraying.

The nanocomposite film is obtained by getting the solvent present to evaporate in an oven at a temperature of between 60°C and 70°C for approximately 10 min.

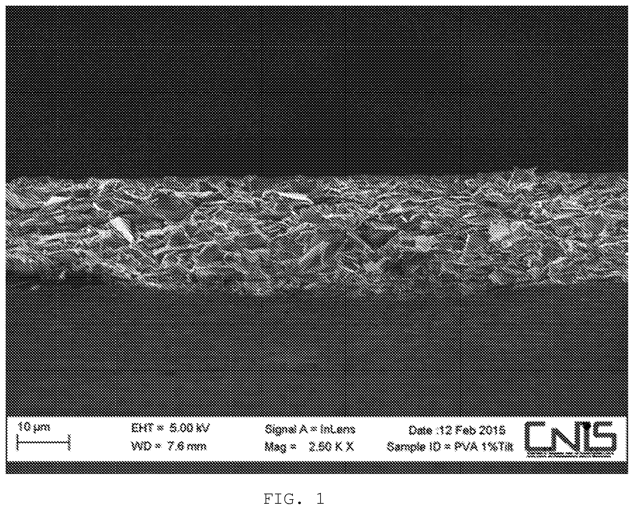

Appearing in Figure 1 is an image acquired with a scanning electron microscope (SEM) of the fracture edge in liquid nitrogen of a film of composite filled at 1%.

### Example No. 2 of the production process: Polyurethane-based paint

The process of production of the polyurethane-based paint forming the subject of the present invention consists of the following steps:
A) PRODUCTION OF EXPANDED GRAPHITE (EG) as per point
   a) of Example No. 1.
   b) DISPERSION AND SHREDDING: the EG is dispersed and shredded in an appropriate amount of 1-propanol (10 ml - 250 ml) with the aid of a mechanical rod stirrer and/or using a high-shear mixer, in a weight percentage ranging between 0.01% and 20%.
   c) ULTRASONICATION AND EXFOLIATION: Next, the suspension is subjected to ultrasonication with 1:1 pulsed cycle with a power of between 40 W and 50 W for a total time of between 20 and 60 min. The solution is kept at a constant temperature of between 5°C and 15°C to prevent evaporation of the solvent and maintain the conditions of sonication unaltered.
   d) EVAPORATION: The suspension is subjected to mixing by magnetic stirring at boiling point so as to remove a fair share of the solvent (from 80% to 90% of the total volume).
   e) HOMOGENISATION: The GNPs thus produced are added to the polyurethane-based paint and mixed with the aid of a high-shear mixer for a time of between 2 and 10 min, at a speed of rotation of between 10000 rpm and 20000 rpm. The suspension is kept at a temperature of between 5°C and 15°C to prevent degradation of the physico-chemical properties of the paint.
   f) ULTRASONICATION: Next, the suspension is subjected to ultrasonication with 1:1 pulsed cycle with a mean power of 4 W, for a total time of between 5 min and 20 min.
   g) HARDENING: At the end of the sonication process a polymerizing agent is added, as per specifications of the producer of the paint.

At the end of the process, the suspension has a viscosity suitable for deposition on the surface of interest in different ways, among which dip-casting, spin-coating, or spraying. The nanocomposite film is obtained by getting the residual solvent present to evaporate in an oven at a temperature of 70°C for approximately 60 minutes.

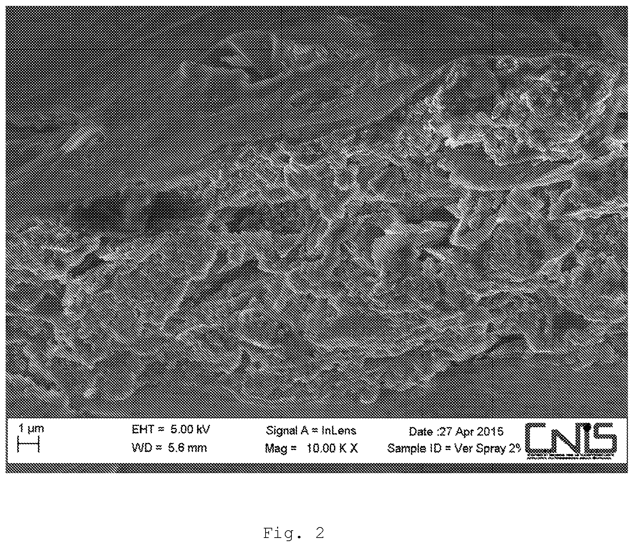

Appearing in Figure 2 is an image acquired with a scanning electron microscope (SEM) of the fracture edge in liquid nitrogen of a film of composite filled at 2%.

### Properties and performance

### Example 1

### (PVA-based) antistatic conductive polymeric film with controlled electrical properties

By measuring the surface resistance of the film obtained at various filler concentrations, it is possible to construct the curve of the electrical resistance as a function of the GNP concentration of the nanocomposite. The measurement process was conducted with a 4-tip probe controlled by a Keithley 6221 AC/DC current generator and a Keithley 2182A nanovoltmeter. The specimens were obtained by isolating a circular portion of film of the diameter of 22 mm, and the surface resistance (*Rₛ*) was calculated according to the formula

*Rₛ* = *R·k*

where R is the resistance measured and k is a corrective factor that depends upon the geometry of the specimen (for the geometry used the value of *k* was 4.44).

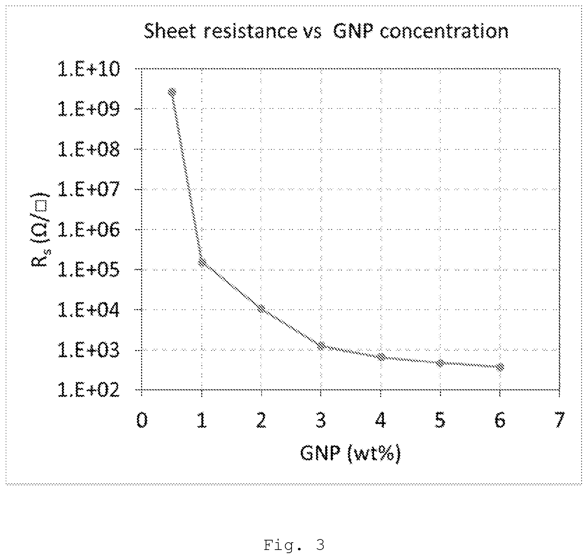

Appearing in Figure 3 is the plot of the surface resistance as a function of the GNP concentration.

### Example 2

### Antistatic conductive polymeric film (polyurethane paint) with controlled electrical properties

By measuring the surface resistance of the film obtained at various filler concentrations, it is possible to construct the curve of the electrical resistance as a function of the GNP concentration of the nanocomposite. The measurement process was conducted with a 4-tip probe controlled by a Keithley 6221 AC/DC current generator and a Keithley 2182A nanovoltmeter. The specimens were obtained by isolating a circular portion of film of the diameter of 22 mm, and the surface resistance (*Rₛ*) was calculated according to the formula

*Rₛ* = *R·k*

where R is the resistance measured and *k* is a corrective factor that depends upon the geometry of the specimen (for the geometry used the value of *k* was 4.44).

Next, the thickness of the conductive paint was measured by means of a profilometer. Knowing the thickness, it is possible to derive the electrical conductivity of the paint, which is comprised between 2 S/m and 14 S/m for a paint with GNP fillers in an amount of between 2 wt% and 4 wt%.

### Example 3

### Piezoresistive polymeric film as strain sensor

To test usability of the composite applied as strain sensor, a layer of conductive film filled at 1% was applied at the centre of a polycarbonate rod with rectangular cross section (24 mm x 6 mm) and a length of 120 mm, over an area of approximately 40 mm x 24 mm. The rod thus sensorized was subjected to three-point bending test. The sensor provided with the deposited polymeric film was contacted at the ends with the silver-based conductive paint for connection of the measurement instrumentation. Also in this case, to monitor the variation of resistance, a Keithley 6221 AC/DC current generator and a Keithley 2182A nanovoltmeter were used. The mechanical test was conducted with an Instron 3366 tensile-test machine with a three-point flexure fixture.

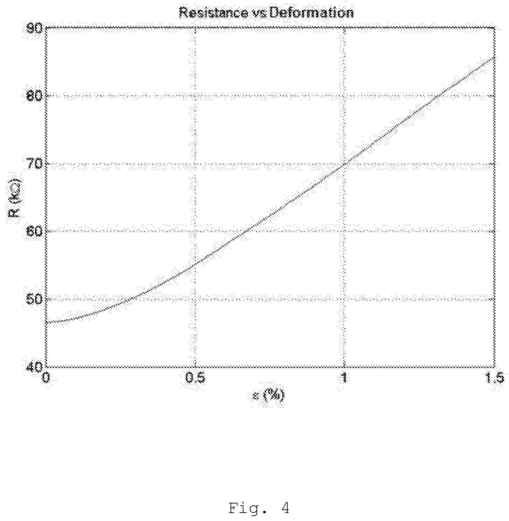

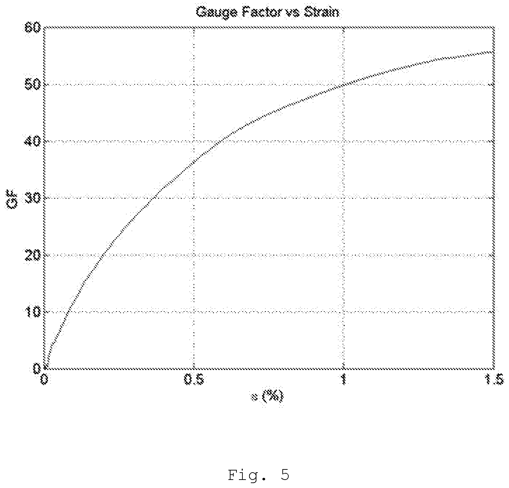

During the bending test the variation of resistance of the film was monitored, from which there were obtained the electromechanical characteristic of the sensor (Figure 4) and the gauge factor (Figure 5).

### Example 4

### Honeycomb RAM panel coated with the nanocomposite polymer

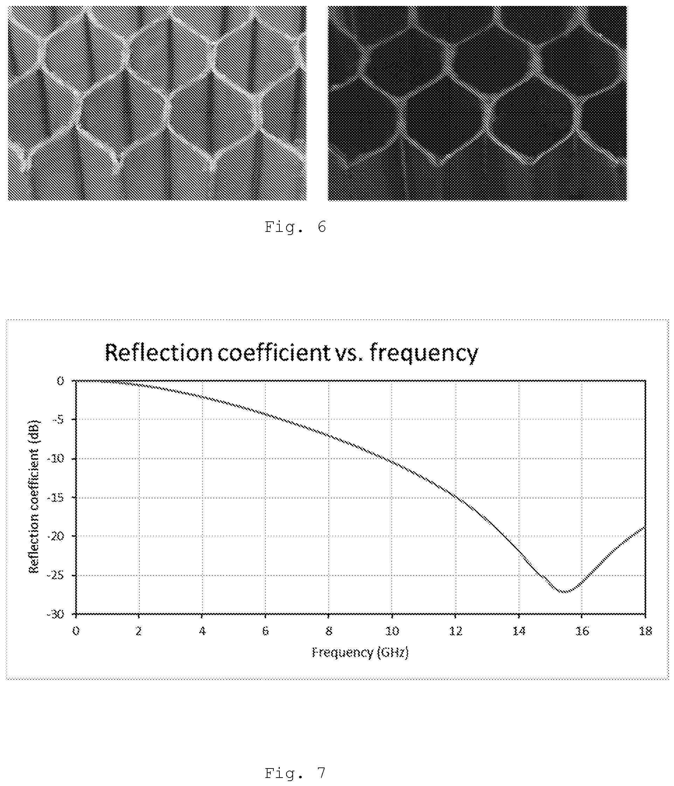

To demonstrate usability of the composite obtained as RAM, a honeycomb panel (Hexcel Honeycomb HRH-10-3/16-6.0) was coated with the PVA-based paint filled with GNPs at 3 wt%. The preselected concentration enables a paint to be obtained with an electrical conductivity of approximately 60 S/m. It was chosen to work on a honeycomb panel in so far as it is a structure that combines a good lightness and a high mechanical strength. Appearing in Figure 6 is a detail of the panel before and after the coating process.

Starting from the measurements of electrical conductivity and from the geometrical properties of the structure, appearing in Figure 7 is the coefficient of reflection of the honeycomb panel shortcircuited on a metal surface in the frequency band 100 kHz -18 GHz.

### INNOVATIVE CHARACTERISTICS OF THE INVENTION

The present invention enables production of a water-based polymeric paint filled with graphene nanoplatelets (GNPs), through a process that is fast, inexpensive, and readily scalable at an industrial level for providing thin conductive, antistatic, and piezoresistive coatings. The material here developed presents electrical, electromagnetic, and piezoresistive characteristics that are clearly superior as compared to the equivalent materials available on the market.

### MAIN AREAS OF APPLICATION

Shielding and radar-absorbent materials, nanotechnologies, electromagnetic compatibility, electrical engineering, strain sensors, structural health monitoring.

### References

[1] "Thermally exfoliated graphite oxide", Patent US7658901, February 9, 2010.
[2] "Graphite nanoplatelets for thermal and electrical applications", Patent US2004/0140792 A1, June 10, 2010.
[3] "A scalable process for producing exfoliated defect-free, non-oxidised 2-dimensional materials in large quantities", Patent WO2014140324A1, March 14, 2014.
[4] "Gnp-based polymeric nanocomposites for reducing electromagnetic interferences", Patent WO2014061048A2, June 10, 2014.
[5] C. Bao, Y. Guo, L. Song e Y. Hu, "Poly(vinyl alcohol) nanocomposites based on graphene and graphite oxide: a comparative investigation of property and mechanism," Journal of Materials Chemistry, vol. 21, pp. 13942-13950, 2011.
[6] H. J. Salvagione, G. Martinez e M. A. Gomez, "Synthesis of poly(vinyl alcohol) reduced graphite oxide nanocomposites with improved thermal and electrical properties", Journal of Materials Chemistry, vol. 19, pp. 5027-5032, 2009.
[7] A. Rinaldi, A. Proietti, A. Tamburrano, G. D. Bellis, M. Mulattieri e M. Sarto, "Multilayer Graphene-based films for strain sensing", in Proceedings of the 14th IEEE International Conference on Nanotechnology, Toronto, 2014.
[8] S. Das et al., "Non-covalent functionalization of pristine few-layer graphene using triphenylene derivatives for conductive poly(vinyl alcohol) composites" , Polymer, vol. 53, pp. 2485-2494, 2012.
[9] T. Zhou, X. Qi e Q. Fu, "The preparation of the poly(vinyl alcohol)graphene nanocomposites with low percolation threshold and high electrical conductivity by using the large-area reduced graphene oxide sheets", Express Polymer Letters, vol. 7, n. 9, pp. 747-755, 2013.
[10] "Water-based polymer thick film conductive ink", Patent US 5286415, February 15, 1994.
[11] "Polymers filled with highly expanded graphite", Patent US 20080171824, July 17, 2008.
[12] "Conductive polyvinyl alcohol and preparation method thereof", March 17, 2010.
[13] "Ultrasonic-assisted method for preparing polymer functionalized graphene", Patent CN 102516829 A, June 27, 2012.
[14] "Conductive polyvinyl alcohol fiber", Patent US 20050181206 A1, August 18, 2005.
[15] "High-performance aqueous graphene paint and preparation method thereof", Patent CN 103131232, June 5, 2013.
[16] "Graphite nanoplatelets and compositions", Patent EP 2262727 A2, December 22, 2010.
[17] "Graphene containing composition", Patent WO 20130074712 A1, May 23, 2013.
[18] "Conductive paint composition and method for manufacturing conductive film using the same", Patent US 201302067294 A1, August 15, 2013.
[19] "Method for manufacturing polyurethane nanocomposite comprising expanded graphite and composition thereof", Patent US 20130001462 A1, January 03, 2013.
[20] "Transparent conductive film comprising water soluble binders", Patent WO 2011008227 A1, August 28, 2012.
[21] "Resin composition for emi shielding, comprising carbon hydride composite", Patent WO 20131057 A1, July 18, 2013.
[22] "Thermoplastic resin composition with EMI shielding properties", Patent US 20140238736 A1, August 28, 2014.
[23] "Emi Shielding material", Patent US 20060247352 A1, November 2, 2006.
[24] "Aqueous emulsion type electromagnetic wave shielded coating and preparation process thereof", Patent CN 1450137, October 22, 2003.
[25] "Smart materials: strain sensing and stress determination by means of nanotube sensing systems, composites and devices", Patent US 20060253942, November 9, 2006.
[26] "Sensing system for monitoring the structural health of composite structures", Patent WO 2006004733 A1, January 12, 2006.
[27] "Structural health monitoring using sprayable paint formulations", Patent WO 2012038720 A1, March 29, 2012.
[28] K. Loh, T. Lynch and N. Kotov, "Carbon Nanotube Sensing Skins for Spatial Strain and Impact Damage Identification," Journal of nondestructive evaluation, vol. 28, pp. 9-25, 2009.
[29] "Electromagnetic field absorbing compsition", Patent WO 20100109174 A1, September 30, 2010.

## Claims

1. A process for producing a water-based conductive polymeric paint containing graphene for providing coatings with radar-absorbent properties or else for producing antistatic devices or piezoresistive coatings, **characterized in that** it comprises the steps of:
a) subjecting to thermal expansion commercial graphite intercalation compound (GIC) to obtain structures known as TEGO, WEG or expanded graphite (EG), or else using EG of a commercial type;
b) dispersing and shredding said TEGO, WEG, or EG structures in a liquid phase chosen in the group of :
- water-based polymeric paint,
- liquid water-based polymer,
- water-based polymeric liquid solution;
- water-based polymeric paint, diluted with an alcohol-water mixture,
- liquid water-based polymer, diluted with an alcohol-water mixture,
- water - based polymeric liquid solution, diluted with an alcohol-water mixture; and
- an alcohol-water mixture; and
c) subjecting the suspension thus obtained to ultrasonication.

2. The process as per Claim 1, wherein the dispersion and shredding referred to in point b) are carried out in water-based paint/ polymer diluted with an alcohol-water mixture, and the volume concentration of water in said alcohol-water mixture used for dilution is comprised between 6% and 65% of the total volume.

3. The process as per Claim 1, wherein the dispersion and shredding referred to in point b) is carried out in an alcohol-water mixture, and after step c) the following substeps are carried out:
c1) partial evaporation of the alcohol-water mixture between 90% and 99% of its volume; and
c2) mixing with water-based polymer and/or paint by mechanical mixing and/or sonication.

4. The process as per Claim 3, wherein the suspension of EG in said alcohol-water mixture has a viscosity of not higher than 5000 cps.

5. The process as per Claim 3, further comprising the subsequent step of:
d) adding a cross-linking agent.

6. The process as per Claim 5, further comprising the subsequent step of:
e) depositing the material thus obtained on the surface of interest by means of dip-casting, spin-coating, spraying, and ink-jet.

7. The process as per Claim 6, further comprising the subsequent step of:
f) obtaining the nanocomposite film by getting the solvent to evaporate by means of a thermal cycle compatible both with the material and with the substrate.

8. The process as per Claim 1, wherein step a) is constituted by heating in an oven at a temperature of between 1000°C and 1250°C, preferably 1150°C, for a time of 5-30 s, preferably 5 s, with rates comprised between 2000°C/min and 15000°C/min, preferably between 10000°C/min and 14000°C/min, preferably 13800°C/min.

9. The process as per as per Claim 1, **characterized in that** step b) is carried out with the aid of a mechanical rod stirrer and/or using a high-shear mixer.

10. The process as per either Claim 1 or Claim 4, **characterized in that** in step b) the optimal ratio between water and expanded graphite is comprised between 0.001 mg/ml and 0.060 mg/ml.

11. The process as per Claim 1, **characterized in that** ultrasonication as per point c) occurs with 1:1 pulsed cycle, with a power of between 40 W and 50 W, from 30-40 min up to a maximum of 80 min, at a temperature of between 5°C and 15°C.

12. The process as per any one of the preceding claims, wherein the alcohol used in the alcohol-water mixture is selected in the group consisting of: 1-propanol, 2-propanol, ethanol.

13. A polymeric film that is obtained through deposition and drying of the polymeric paint obtained with the process according to any one of Claims 1 to 12, as piezoresistive coating for strain sensing.

14. Use of the polymeric film that is obtained through deposition and drying of the polymeric paint obtained with the process according to any one of Claims 1 to 12, as lossy layer in radar-absorbent multilayers for radiofrequency applications.

15. Use of the polymeric film that is obtained through deposition and drying of the polymeric paint obtained with the process according to any one of Claims 1 to 12, as coating for aramidic honeycomb structures to obtain ultralight structures with good properties of absorption of electromagnetic fields.

16. Use of the polymeric film that is obtained through deposition and drying of the polymeric paint obtained with the process according to any one of Claims 1 to 12, for application on structures and components for strain monitoring.

17. A strain sensor comprising a piezoresistive polymeric film according to Claim 13, applied on a substrate of any nature.

18. The process as per Claim 1, **characterized in that** the water-based polymer or paint used in step b) has a base of PVA or polyurethane or another water-mixable polymer.

## Patentansprüche

1. Verfahren zur Herstellung eines wasserbasierten leitfähigen polymeren Lacks, der Graphen enthält, um Beschichtungen mit radarabsorbierenden Eigenschaften bereitzustellen oder auch antistatische Vorrichtungen oder piezoresistive Beschichtungen herzustellen, **dadurch gekennzeichnet, dass** es die Schritte umfasst:
a) Unterziehen einer handelsüblichen Graphitinterkalationsverbindung (GIC) einer thermischen Ausdehnung, um Strukturen zu erhalten, die als TEGO, WEG oder expandierter Graphit (EG) bekannt sind, oder auch Verwenden von EG eines handelsüblichen Typs;
b) Dispergieren und Zerkleinern der TEGO-, WEG- oder EG-Strukturen in einer flüssigen Phase, die aus der folgenden Gruppe ausgewählt wird:
- wasserbasierter polymerer Lack,
- flüssiges wasserbasiertes Polymer,
- wasserbasierte polymere flüssige Lösung;
- wasserbasierter polymerer Lack, verdünnt mit einem Alkohol-Wasser-Gemisch,
- flüssiges wasserbasiertes Polymer, verdünnt mit einem Alkohol-Wasser-Gemisch,
- wasserbasierte polymere flüssige Lösung, verdünnt mit einem Alkohol-Wasser-Gemisch; und
- ein Alkohol-Wasser-Gemisch; und
c) Unterziehen der so erhaltenen Suspension einer Ultraschallbehandlung.

2. Verfahren nach Anspruch 1, wobei das Dispergieren und Zerkleinern gemäß Punkt b) in einem wasserbasierten Lack/einem wasserbasierten Polymer durchgeführt wird, verdünnt mit einem Alkohol-Wasser-Gemisch, und die Volumenkonzentration von Wasser in dem Alkohol-Wasser-Gemisch, das zur Verdünnung verwendet wird, zwischen 6 % und 65 % des Gesamtvolumens umfasst.

3. Verfahren nach Anspruch 1, **dadurch gekennzeichnet, dass** das Dispergieren und Zerkleinern gemäß Punkt b) in einem Alkohol-Wasser-Gemisch durchgeführt wird, und nach Schritt c) die folgenden Teilschritte durchgeführt werden:
c1) teilweises Verdampfen des Alkohol-Wasser-Gemischs zwischen 90 % und 99 % seines Volumens; und
c2) Mischen mit einem wasserbasierten Polymer und/oder Lack durch mechanisches Mischen und/oder Beschallen.

4. Verfahren nach Anspruch 3, wobei die Suspension von EG in dem Alkohol-Wasser-Gemisch eine Viskosität von nicht mehr als 5000 cps aufweist.

5. Verfahren nach Anspruch 3, ferner umfassend den nachfolgenden Schritt:
d) Zugeben eines Vernetzungsmittels.

6. Verfahren nach Anspruch 5, ferner umfassend den nachfolgenden Schritt:
e) Aufbringen des so erhaltenen Materials auf die gewünschte Oberfläche durch Mittel aus Tauchbeschichtung, Spin-Coating, Sprühen, und Tintenstrahlverfahren.

7. Verfahren nach Anspruch 6, ferner umfassend den nachfolgenden Schritt:
f) Erhalten des Nanokompositfilms durch Verdampfen des Lösungsmittels mittels eines thermischen Zyklus, der sowohl mit dem Material als auch mit dem Substrat kompatibel ist.

8. Verfahren nach Anspruch 1, wobei Schritt a) durch Erhitzen in einem Ofen bei einer Temperatur zwischen 1000°C und 1250°C, bevorzugt 1150°C, für eine Zeit von 5-30 s, bevorzugt 5 s, mit Raten zwischen 2000°C/min und 15000°C/min, bevorzugt zwischen 10000°C/min und 14000°C/min, bevorzugt 13800°C/min, durchgeführt wird.

9. Verfahren nach Anspruch 1, **dadurch gekennzeichnet, dass** Schritt b) mit Hilfe eines mechanischen Stabrührers und/oder unter Verwendung eines Hochschermischers durchgeführt wird.

10. Verfahren nach Anspruch 1 oder Anspruch 4, **dadurch gekennzeichnet, dass** in Schritt b) das optimale Verhältnis zwischen Wasser und expandiertem Graphit zwischen 0,001 mg/ml und 0,060 mg/ml umfasst.

11. Verfahren nach Anspruch 1, **dadurch gekennzeichnet, dass** die Ultraschallbehandlung gemäß Punkt c) mit einem 1:1-Impulszyklus, mit einer Leistung zwischen 40 W und 50 W, von 30-40 min bis zu maximal 80 min, bei einer Temperatur zwischen 5°C und 15°C erfolgt.

12. Verfahren nach einem der vorhergehenden Ansprüche, wobei der in dem Alkohol-Wasser-Gemisch verwendete Alkohol ausgewählt ist aus der Gruppe bestehend aus: 1-Propanol, 2-Propanol, Ethanol.

13. Polymerer Film, der durch Aufbringen und Trocknen des polymeren Lacks erhalten wird, der mit dem Verfahren gemäß einem der Ansprüche 1 bis 12 erhalten wird, als piezoresistive Beschichtung zur Dehnungsmessung.

14. Verwendung des polymeren Films, der durch Aufbringen und Trocknen des polymeren Lacks erhalten wird, der mit dem Verfahren gemäß einem der Ansprüche 1 bis 12 erhalten wird, als verlustbehaftete Schicht in radarabsorbierenden Multischichten für Hochfrequenzanwendungen.

15. Verwendung des polymeren Films, der durch Aufbringen und Trocknen des polymeren Lacks erhalten wird, der mit dem Verfahren gemäß einem der Ansprüche 1 bis 12 erhalten wird, als Beschichtung für aramidische Wabenstrukturen, um ultraleichte Strukturen mit guten Eigenschaften der Absorption elektromagnetischer Felder zu erhalten.

16. Verwendung des polymeren Films, der durch Aufbringen und Trocknen des polymeren Lacks erhalten wird, der mit dem Verfahren gemäß einem der Ansprüche 1 bis 12 erhalten wird, zur Anwendung auf Strukturen und Komponenten zur Belastungsüberwachung.

17. Dehnungssensor, umfassend einen piezoresistiven polymeren Film gemäß Anspruch 13, der auf ein Substrat beliebiger Art aufgebracht ist.

18. Verfahren nach Anspruch 1, **dadurch gekennzeichnet, dass** das wasserbasierte Polymer oder der wasserbasierte Lack, das/der in Schritt b) verwendet wird, eine Basis aus PVA oder Polyurethan oder einem anderen wassermischbaren Polymer aufweist.

## Revendications

1. Procédé de production d'une peinture polymère conductrice à base aqueuse contenant du graphène pour conférer à des revêtements des propriétés d'absorption des ondes radar ou bien pour produire des dispositifs antistatiques ou des revêtements piézorésistifs, **caractérisé en ce qu'**il comprend les étapes de :
a) soumission à une expansion thermique d'un composé d'insertion du graphite (GIC) commercial pour obtenir des structures appelées TEGO, WEG ou graphite expansé (EG), ou bien utilisation d'EG d'un type commercial ;
b) dispersion et fragmentation desdites structures TEGO, WEG ou EG dans une phase liquide choisie dans le groupe suivant :
- une peinture polymère à base aqueuse,
- un polymère liquide à base aqueuse,
- une solution liquide polymère à base aqueuse;
- une peinture polymère à base aqueuse, diluée avec un mélange d'alcool et d'eau,
- un polymère liquide à base aqueuse, dilué avec un mélange d'alcool et d'eau,
- une solution liquide polymère à base aqueuse, diluée avec un mélange d'alcool et d'eau ; et
- un mélange d'alcool et d'eau ; et
c) soumission de la suspension ainsi obtenue à une ultrasonication.

2. Procédé selon la revendication 1, dans lequel la dispersion et la fragmentation mentionnées au point b) sont mises en oeuvre dans une peinture/un polymère à base aqueuse dilués avec un mélange d'alcool et d'eau, et la concentration volumique d'eau dans ledit mélange d'alcool et d'eau utilisé pour la dilution est comprise entre 6 % et 65 % du volume total.

3. Procédé selon la revendication 1, dans lequel la dispersion et la fragmentation mentionnées au point b) sont mises en oeuvre dans un mélange d'alcool et d'eau, et après l'étape c) les sous-étapes suivantes sont mises en oeuvre :
c1) l'évaporation partielle du mélange d'alcool et d'eau entre 90 % et 99 % de son volume ; et
c2) le mélange avec un polymère et/ou une peinture à base aqueuse par mélange mécanique et/ou sonication.

4. Procédé selon la revendication 3, dans lequel la suspension d'EG dans ledit mélange d'alcool et d'eau présente une viscosité inférieure ou égale à 5 000 cps.

5. Procédé selon la revendication 3, comprenant en outre l'étape suivante :
d) l'ajout d'un agent de réticulation.

6. Procédé selon la revendication 5, comprenant en outre l'étape suivante :
e) le dépôt de la matière ainsi obtenue sur la surface d'intérêt au moyen d'une coulée par immersion, d'une application par centrifugation, d'une pulvérisation et d'un jet d'encre.

7. Procédé selon la revendication 6, comprenant en outre l'étape suivante :
f) l'obtention du film nanocomposite en amenant le solvant à s'évaporer au moyen d'un cycle thermique compatible à la fois avec la matière et avec le substrat.

8. Procédé selon la revendication 1, dans lequel l'étape a) consiste en le chauffage dans un four à une température comprise entre 1 000 °C et 1 250 °C, de préférence 1 150 °C, pendant une durée de 5-30 s, de préférence 5 s, avec des vitesses comprises entre 2 000 °C/min et 15 000 °C/min, de préférence entre 10 000 °C/min et 14 000 °C/min, de préférence 13 800 °C/min.

9. Procédé selon la revendication 1, **caractérisé en ce que** l'étape b) est mise en oeuvre avec l'aide d'un agitateur mécanique et/ou l'utilisation d'un mélangeur à cisaillement élevé.

10. Procédé selon l'une ou l'autre de la revendication 1 ou de la revendication 4, **caractérisé en ce qu'**à l'étape b) le rapport optimal entre l'eau et le graphite expansé est compris entre 0,001 mg/ml et 0,060 mg/ml.

11. Procédé selon la revendication 1, **caractérisé en ce que** l'ultrasonication conformément au point c) a lieu selon un cycle pulsé 1:1, avec une puissance comprise entre 40 W et 50 W, de 30-40 min jusqu'à un maximum de 80 min, à une température comprise entre 5 °C et 15 °C.

12. Procédé selon l'une quelconque des revendications précédentes, dans lequel l'alcool utilisé dans le mélange d'alcool et d'eau est sélectionné dans le groupe consistant en : le 1-propanol, le 2-propanol, l'éthanol.

13. Film polymère qui est obtenu par le dépôt et le séchage de la peinture polymère obtenue avec le procédé selon l'une quelconque des revendications 1 à 12, en tant que revêtement piézorésistif destiné à la détection de contraintes.

14. Utilisation du film polymère qui est obtenu par le dépôt et le séchage de la peinture polymère obtenue avec le procédé selon l'une quelconque des revendications 1 à 12, en tant que couche de perte dans des multicouches absorbant les ondes radar pour des applications radiofréquence.

15. Utilisation du film polymère qui est obtenu par le dépôt et le séchage de la peinture polymère obtenue avec le procédé selon l'une quelconque des revendications 1 à 12, en tant que revêtement pour des structures aramides en nid d'abeille pour obtenir des structures ultralégères avec de bonnes propriétés d'absorption de champs électromagnétiques.

16. Utilisation du film polymère qui est obtenu par le dépôt et le séchage de la peinture polymère obtenue avec le procédé selon l'une quelconque des revendications 1 à 12, destiné à une application sur des structures et des composants pour la surveillance de contraintes.

17. Capteur de contraintes comprenant un film polymère piézorésistif selon la revendication 13, appliqué sur un substrat d'une nature quelconque.

18. Procédé selon la revendication 1, **caractérisé en ce que** le polymère ou la peinture à base aqueuse utilisé(e) à l'étape b) présente une base de PVA ou de polyuréthane ou d'un autre polymère diluable à l'eau.
